Europäisches Patentamt

European Patent Office

Office européen des brevets

(19)

(11) Veröffentlichungsnummer: **0 253 764 B1**

(12) **EUROPÄISCHE PATENTSCHRIFT**

(45) Veröffentlichungstag der Patentschrift: 06.03.91

(51) Int. Cl.⁵: **B23K 26/04**, H01L 23/00

(21) Anmeldenummer: 87810355.5

(22) Anmeldetag: 23.06.87

(54) Verfahren und Vorrichtung zur Erhöhung der Systemsicherheit bei einem Laser-Schreibverfahren.

(30) Priorität: 25.06.86 CH 2565/86

(43) Veröffentlichungstag der Anmeldung:
20.01.88 Patentblatt 88/03

(45) Bekanntmachung des Hinweises auf die
Patenterteilung:
06.03.91 Patentblatt 91/10

(84) Benannte Vertragsstaaten:
AT BE CH DE ES FR GB GR IT LI LU NL SE

(56) Entgegenhaltungen:
EP-A- 0 108 893
EP-A- 0 128 993
EP-A- 0 168 351
US-A- 4 213 117

INTERNATIONAL ELECTRON DEVICES MEE-
TING, San Francisco, 13.-15. Dezember 1982,
Seiten 407-410; T. MATSUDA et al.: "High
precision lithography for submicron VLSI fabrication"

(73) Patentinhaber: **LASARRAY HOLDING AG**

**CH-8512 Thundorf(CH)**

(72) Erfinder: **Kempter, Meinrad**
**Tulpenweg 16**
**CH-3250 Lyss(CH)**
Erfinder: **Glauser, Paul**
**Grendelbachstrasse 13**
**CH-8307 Effretikon(CH)**

(74) Vertreter: **Frauenknecht, Alois J. et al**
**c/o PPS Polyvalent Patent Service AG, Mel-**
**lingerstrasse 1**
**CH-5400 Baden(CH)**

## Beschreibung

Die vorliegende Patentanmeldung betrifft ein Verfahren und eine Vorrichtung zur Erhöhung der Sicherheit bei der Erkennung von Referenzdaten bei einem Laser-Schreibverfahren mittels eines Laser-Pattern-Generators, wobei ein von der Oberfläche eines bearbeiteten Werkstückes beeinflusster Tastlaserstrahl mit wenigstens einem Tastlaserstrahl-Detektor empfangen wird.

Es ist ein Laser-Pattern-Generator und Verfahren zu dessen Betrieb bekannt (EP -A1 - 0 168 351). Es werden ein Schreiblaserstrahl und ein Tastlaserstrahl verwendet, wobei der letztere die Oberfläche des Chips (Werkstückes) abtastet und in wenigstens einen Detektor reflektiert wird. Ein vorgefertigtes Werkstück enthält eine Platte aus einem nichtmetallischen Material, auf der ein metallisiertes Raster aufgetragen ist. Bei der Werkstückbearbeitung ist eine richtige Orientierung des Schreiblaserstrahls notwendig. Bisher wurden die Analogsignale, die mit dem Detektor empfangen sind, direkt ausgewertet.

Die Nachteile dieses Verfahrens bestehen vor allem darin, dass die metallisierte Schicht des Werkstückes Zonen aufweist, in welchen scheinbar Aussparungen vorhanden sind, sodass der Tastlaserstrahl eine Unterbrechung signalisiert.

Aus dem Dokument INTERNATIONAL ELECTRON DEVICES MEETING, San Francisco, 13. - 15. Dezember 1982, Seiten 407 - 410, T. Matsude et al: "High precision lithography for submicron VLSI fabrication" ist ein Verfahren zur verbesserten Markierungserkennung und Bestimmung der Markierungslage bei direkten Schreibverfahren zur Herstellung von Submikro-Chips mittels eines veränderlich geformten Elektronenstrahls bekannt. Bei diesem Verfahren werden Signale eines Pegelkompensators digitalisiert und mit einer Referenz (erster Schwellenwert) verglichen. Diese Daten werden vorerst in einen Speicher für die Markierungskanten eingegeben. Nach Beendigung der Abtastung werden die Speicherdaten einem Computer zur Bestimmung der Markierungskanten zugeführt. Bei jeder Abtastung der Speicherwerte wird ein Zeitfenster ausgeschnitten (window processing). Ein auf diesem Ergebnis beruhendes Histogramm wird mit einer weiteren Referenz (zweiter Schwellenwert) verglichen, um die Breite für das Vorliegen der Markierungskanten zu erkennen. Das Mittel zwischen Minimal-und Maximalwerten ergibt die Lage der Markierungskante. Schliesslich wird die endgültige Lage der Markierung durch Mittelung der Markierungskantenlagen bestimmt. Durch dieses Verfahren sollen aus einem detektierten Signal Störsignale eliminiert werden.

Die auf dem Chip vorhandenen Strukturen weisen eine Grössenordnung von 0,1 bis 1,0 μm auf, so dass es notwendig ist, beim Abtasten sehr früh Entscheidungen zu treffen, um feststellen zu können, ob es sich um eine Aussparung handelt oder nicht. Dies sollte spätestens etwa 1 bis 2 μm nach Eintritt in die Aussparung klar identifiziert werden. Es besteht jedoch die Gefahr, dass irgendwelche Störungen der abgetasteten Oberfläche unerwünschte Entscheidungen hervorrufen können, was wiederum fehlerhafte Belichtungen, z.B. auf der metallisierten Fläche, zur Folge hätte.

Die Aufgabe der Erfindung besteht darin, die obenerwähnten Nachteile zu beseitigen und ein Verfahren der eingangs genannten Art zu schaffen, welches solche Fehler der Auswertung des beeinflussten Tastlaserstrahls infolge der Oberflächenrauhigkeit des abgetasteten Werkstückes verhindert.

Diese Aufgabe wird durch ein Verfahren erfindungsgemäss dadurch gelöst, dass die Signale des Tastlaserstrahls, die unter Anbringen eines Eintrittscodes am Rande des Werkstückes von diesem beeinflusst und durch den Tastlaserstrahl-Detektor erfasst werden, in ein digitales Signal umgewandelt werden, das einer Steuer-Logik und einem Synchronisator zugeführt wird, dass die Steuer-Logik durch ein Steuer-Signal in einen Spurmuster-Speicher zugeführt wird, dass danach die Steuer-Logik die Ausgabe des gespeicherten Spurmusters steuert, dass dieses Spurmuster dem Synchronisator zugeführt wird, dass mittels des Synchronisators das digitale Detektor-Signal des Tastlaserstrahls und das synthetische Signal verglichen werden und das relevante empfangene Signal für die Steuerung der gegenseitigen Bewegung des Schreiblaserstrahls und des Werkstücks ausgegeben wird.

Dies bedeutet, dass das auf dem Chip sich befindende Raster, z.B. ein Metallraster, in einem Speicher als Muster abgelegt und mit Hilfe eines Eintrittscodes synchron zum Abtasten bereitgestellt wird. Das vom Detektor empfangene Signal wird auf die Übereinstimmung mit dem gespeicherten Muster geprüft. Die Resultate des Vergleichs werden für die Spurpositionierung verwendet. Der Vorteil ist also darin zu sehen, dass die eventuelle Oberflächenrauhigkeit keine falschen Befehle für den Laser-Pattern-Generator verursachen kann.

Anstelle des als Beispiel erwähnten Metallrasters kommen auch nichtmetallische Raster oder projizierte rasterähnliche Bilder in Frage.

Es ist zweckmässig, wenn nach Anspruch 2 das digitale Detektor-Signal durch Wegimpulse in ein Schieberegister eingetaktet wird, dass von jeder Position des Schieberegisters ein Ausgangssignal geliefert und nach der jeweiligen Aussagekraft gewichtet wird, dass die Summe aller gewichteten Ausgangssignale des Schieberegisters mit einem maximal zulässigen Fehlersignal verglichen wird und dass bei Unterschreiten dieser Schwelle in einem Komparator ein digitales Synchronisations-Signal erzeugt wird. Diese Lösung gibt eine vorteilhafte Möglichkeit der Erkennung von fehlerhaften Struk turen. Die Ausgangssignale des Schieberegister werden so gewählt, dass bei erwartetem Signalpegel das Ausgangssignal Null wird.

Die Erfindung bezieht sich auch auf eine Vorrichtung zur Steuerung eines Laser-Pattern-Generators für ein Laser-Schreibverfahren, mit wenigsten einem Tastlaserstrahl-Detektor zum Empfang eines von der Oberfläche eines bearbeiten Werkstücks beeinflussten Tastlaserstrahls.

Die erfindungsgemässe Vorrichtung ist dadurch gekennzeichnet, dass an den Tastlaserstrahl-Detektor ein analog/digitaler-Umwandler angeschlossen ist, dessen Ausgang mit einem Synchronisator und einer Steuer-Logik verbunden ist, wobei die Steuer-Logik an den Eingang eines Spurmuster-Speichers führt, dessen Ausgang eine Verbindung für gespeicherte Daten an den Synchronisator aufweist, der mit einem Weg für Korrektursignale für die Steuer-Logik und mit einem Anschluss für die Steuerung des Laser-Pattern-Generators versehen ist. Diese Schaltung ist vereinfacht, um die Übersichtlichkeit der Lösung klar darzustellen. Es ist selbstverständlich, dass einzelne Bestandteile verschiedene an sich bekannte Ausfertigungen aufweisen können.

Die Erfindung wird anhand einiger Zeichnungen näher erläutert.

Es zeigen:

Fig. 1    ein beispielsweises Grundschema der erfindungsgemässen Vorrichtung,

Fig. 2    ein beispielsweises, ausführlicher dargestelltes Schema der erfindungsgemässen Vorrichtung mit bezeichneten Verbindungsleitungen,

Fig. 3    eine beispielsweise Ausfertigung eines Synchronisations-Muster-Korrelators und

Fig. 4    die zur Fig. 3 gehörenden Kurven für die entsprechenden Signale.

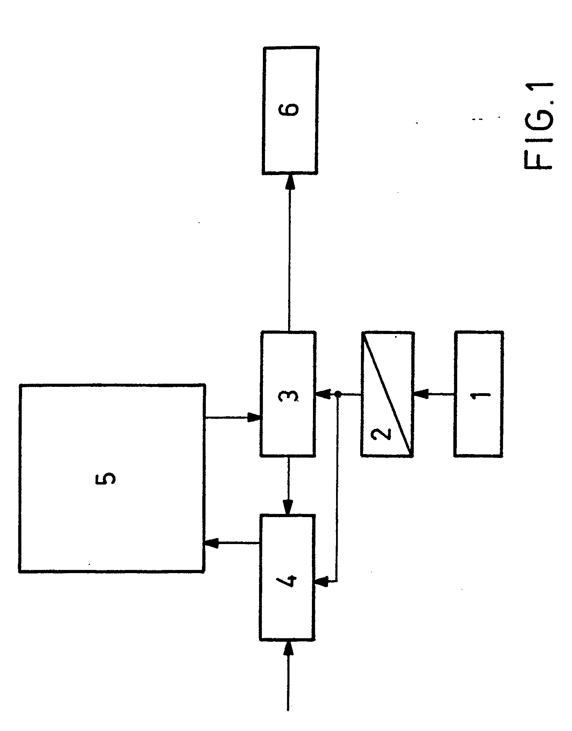

Gemäss Fig. 1 ist ein Tastlaserstrahl-Detektor mit 1 bezeichnet. In den gezeigten Beispielen ist als digitales Signal das übliche binäre Signal verwendet. Ein analog/binärer Umwandler 2 ist an einen Synchronisator 3 und eine Steuer-Logik 4 angeschlossen. Die Steuer-Logik 4 wird an den Eingang eines Spurmuster-Speichers 5 zugeführt, wobei der Ausgang dieses Spurmuster-Speichers 5 an den Synchronisator 3 angeschlossen ist. Die Steuer-Logik 4 empfängt zusätzlich ein Wegsignal, das in der Fig. 1 als ein Pfeil dargestellt ist, der die linke Seite des Schemablocks für die Steuer-Logik 4 berührt.

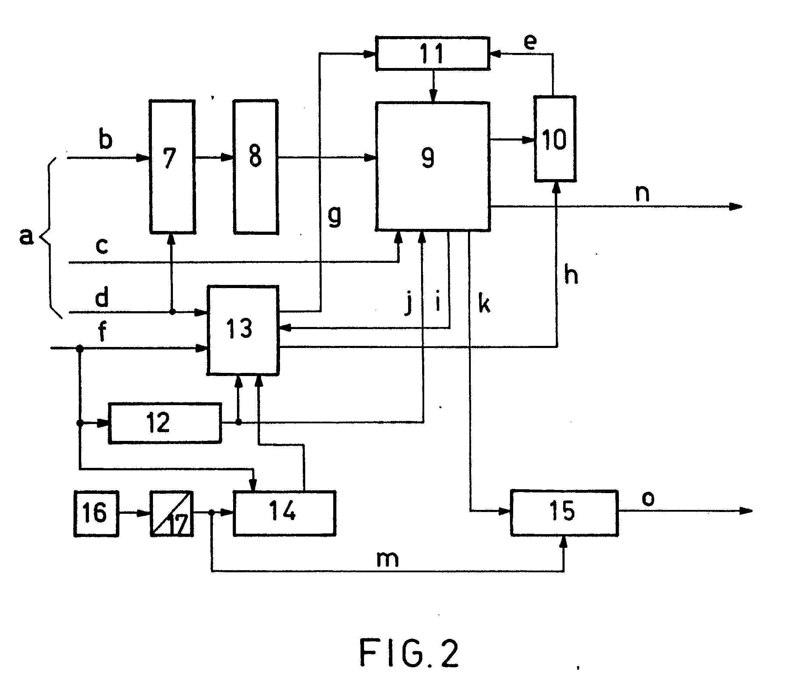

Gemäss der Fig. 2 werden in einem Spurzähler 7 die Impulse für jeweils eine gesamte Zeile innerhalb eines Werkstückes gezählt. Ein Chip enthält z.B. 500 Zeilen. Es gibt selbstverständlich verschiedene Arten von Werkstücken. Aus diesem Grunde müssen bei einem Wechsel von einem Chip auf den anderen Impulse vorhanden sein, die als Spurimpulse b (Track steps) bezeichnet sind. Diesen gezählten Spuren werden dann über eine Spurenauswahl 8, die auch als Spurendekodierung bezeichnet werden kann, Muster innerhalb des Chips oder des Laser-Generators zugeordnet. Der nächste Funktionsblock ist ein Spurmuster-Speicher 9, in welchem sämtliche vorkommendenunterschiedliche Spurmuster abgelegt sind. Das gespeicherte Muster wird dann in ein Musterzeitglied 10 geführt, wo die nötige zeitliche Expansion mit Hilfe von Wegimpulsen vorgenommen wird. Das bedeutet, dass die Muster im Spurmuster-Speicher 9 als komprimierte Form vorliegen können. Das Musterzeitglied 10 kann im Prinzip auch ein Bestandteil des Spurmuster-Speichers 9 sein. In einem Musterzähler 11 wird jeweils die von der Spurenauswahl 8 ausgewählte Spur ausgelesen und dem Musterzeitglied 10 zugeführt.

Die Bearbeitungsrichtung c (x-y-selection) führt direkt in den Spurmuster-Speicher 9 und gibt sodann die entsprechende Information über die Bearbeitungsrichtung. Jeweils am Anfang einer neuen Chip-Reihe beginnt der Spurzähler 7 wieder von Null mit Hilfe von Spurimpulsen b aufwärts zu zählen. Die Impulse f im 0,2 μm Takt werden der Steuer-Logik 13 zugeführt. Der Sprung d (chip step) beeinflusst sowohl den Spurzähler 7 als auch die Steuer-Logik 13. Die Funktionen b,c,d bilden die Steuerung a. Die Steuer-Logik 13 übernimmt dann die Steuerung und die Synchronisation, die mit dem neuen Eintrittscode und dem Spurmuster-Taktsignal g den Musterzähler 11 startet, um das Muster korrekt auszutasten. Die Impulse f im 0,2 μm Takt erreichen dann das Musterzeitglied 10, das das nächste Muster e liefert. Die Steuer-Logik 13 erhält ein Signal vom Fahrrichtungsdiskriminator 12, der anzeigt, in welche Richtung sich der Tisch mit dem Werkstück bewegt. Durch den Muster-Takt h wird das Musterzeitglied beeinflusst. In einem Synchronisations-Muster-Korrelator 14 sind die gesamten digital gespeicherten Informationen enthalten.

Am Rand des Chips befindet sich das Synchronisations-Muster, das mit Hilfe des Synchronisations-Muster-Korrelators 14 erkannt wird, wobei gewisse Fehler toleriert werden. Es wird z.B. eine Genauigkeit von 0,5 μm toleriert. Im Synchronkorrelator 15 wird das Analog-Signal, das wir vom Tastlaser strahl-Detektor 16 erhalten, mit dem Muster des SpurmusterSpeichers 9 verglichen.

Es gibt zwei Alternativen: Das digitale Muster wird ausgegeben und die zeitliche Lage zum analogen Signal im Bedarfsfall korrigiert. Das Analog-Signal hat nur noch synchronisierende Wirkung.

Das digitale Signal kann andererseits zur Verbesserung des Signalrauschverhältnisses dem Analog-Signal überlagert werden, wobei die Summe der Signale die Daten für die Steuerung liefert. Der Synchronisations-Muster-Korrelator 14 gibt bei grösstmöglicher Übereinstimmung zu gefordertem Muster ein binäres Synchronisations-Signal, das die Steuer-Logik 13 ansteuert. Im Synchronkorrelator 15 findet die Synchronisation des synthetischen binären Detektor-Signals m mit dem binären Detektor-Signal statt.

Es wird also festgestellt, ob der Tastlaserstrahl vom Raster oder vom Werkstück selbst, z.B. vom Metall oder vom Nichtmetall, reflektiert bzw. beeinflusst wird. Das synthetische Signal gibt ein Fenster vor, innerhalb dessen das binäre Detektorsignal m das Aussparungssignal liefern muss. Danach wird der Weg entsprechend korrigiert. Eine Abhängigkeit der Gesamtsteuerung in bezug auf die Zeit besteht nicht, Wegimpulse können entweder durch ein Mess-System generiert werden oder durch eine Schritt-Motorsteuerung, die dann bei jedem Schritt einen Wegimpuls ausgibt. Es erfolgt also keine Synchronisation einmalig pro Strasse, sondern pro einzelnen Chip. Innerhalb eines Chips nach dem Erkennen des Eintritts-Codes durch den Synchronisations-Muster-Korrelator 14 wird das Muster ausgetaktet und mit Hilfe des Synchronkorrelators 15 erfolgt dann eine zusätzliche Synchronisation innerhalb des Chips, um Verzug, Ausdehnung etc. abzufangen. Die noch nicht erwähnten bezeichneten Verbindungsleitungen in Fig. 2 dienen als Synchronisation i, Fahrrichtung-Information j, gespeicherte Daten k, binäres Detektor-Signal m, Spurpositionierung n und gültiges Spurmuster o (Rastersignal).

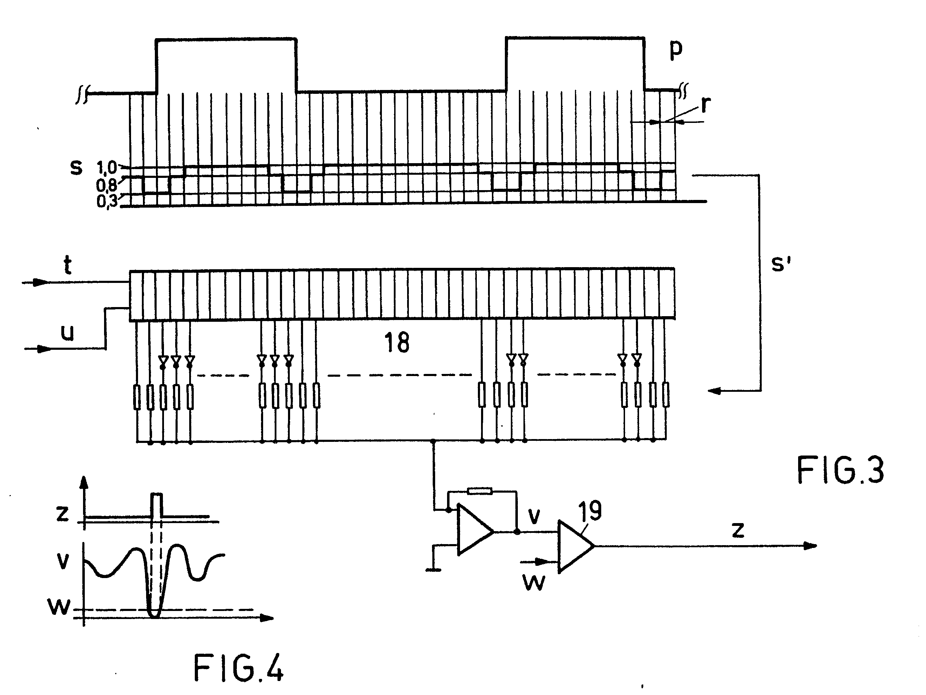

Fig. 3 zeigt eine beispielsweise Ausfertigung eines Synchronisations-Muster-Korrelators 14. Die Vorrichtung enthält ein Schieberegister 18, wobei mit dieser Bezugsziffer das Schieberegister als Ganzes bezeichnet ist. Im oberen Teil der Fig. 3 ist der Verlauf der Eintrittsstruktur p dargestellt. Die Wegimpulse weisen die Abstände r auf. Im linken Teil der Zeichnung ist die gewählte Gewichtung s mit den Werten von 0,3; 0,8 und 1,0 dargestellt. An den Eingang des Schieberegisters 18 wird ein binäres Detektor-Signal t geführt und gleichzeitig auch die Wegimpulse u. Die Gewichtung s' ist zwischen dem Diagramm und dem Schieberegister 18 symbolisch mit s' bezeichnet. An den gemeinsamen Ausgang des Schieberegisters 18 ist ein Verstärker angeschlossen, von welchem die Summe v der Ausgangssignale in einen Komparator 19 geführt wird, wo der Vergleich mit dem maximalen Fehlersignal w aus dem Komparator 19 stattfindet. Somit wird das Synchronisations-Signal z erreicht.

In der Fig. 4 sind die Verläufe im Komparator 19 graphisch dargestellt. Im unteren Teil der Fig. 4 ist die Summe v der Ausgangssignale des Schieberegisters 18 und das maximale Fehlersignal w gezeigt. Im oberen Teil ist das resultierende Synchronisations-Signal z veranschaulicht.

Bei dem erfindungsgemässen Verfahren liefert ein Mess-System die nötigen Impulse, die als Mass für den zurückgelegten Weg dienen. Die Feststellung der x-y-Position des Werkstückes wird dazu benutzt, um das Muster mit der richtigen Geschwindigkeit nach dem Eintritt am Chiprand aus dem Spurmuster-Speicher 5 korrekt auszutasten.

Die Vorteile der vorliegenden Erfindung sind vor allem darin zu sehen, dass kleine Störungen an der Rasteroberfläche oder scheinbare Aussparungen, die zu Fehlentscheidungen führen könnten, durch die Anordnung blockiert werden. Bei einem Rasterabstand von z.B. 8 bis 13 μm kann die zweite Aussparung also sehr präzise unter Mikrometer-Genauigkeit vorhergesagt werden. Somit können die Abmessungen in der Oberfläche des Werkstückes vermindert werden, z.B. die Breite der Aussparung kann auf 2 μm heruntergehen. Dies ermöglicht auch, dass die Synchronisation in grösseren Abständen stattfindet.

## Ansprüche

1. Verfahren zur Erhöhung der Sicherheit bei der Erkennung von Referenzdaten bei einem Laser-Schreibverfahren mittels eines Laser-Pattern-Generators, wobei ein von der Oberfläche eines bearbeiteten Werkstückes beeinflusster Tastlaserstrahl mit wenigstens einem Tastlaserstrahl-Detektor (1) empfangen wird, dadurch gekennzeichnet, dass die Signale des Tastlaserstrahls, die unter Anbringen eines Eintrittscodes am Rande des Werkstückes von diesem beeinflusst und durch den Tastlaserstrahl-Detektor (1) erfasst werden, in ein digitales Signal umgewandelt werden, das einer Steuer-Logik (4) und einem Synchronisator (3) zugeführt wird, dass die Steuer-Logik (4) durch ein Steuer-Signal in einen Spurmuster-Speicher (5) zugeführt wird, dass danach die Steuer-Logik (4) die Ausgabe des gespeicherten Spurmusters steuert, dass dieses Spurmuster dem Synchronisator (3) zugeführt wird, dass mittels des Synchronisators (3) das digitale Detektor-Signal des Tastlaser-Strahls und das synthetische Signal verglichen werden und das relevante empfangene Signal für die Steuerung der gegenseitigen Bewegung des Schreiblaserstrahls und des Werkstücks ausgegeben wird.

2. Verfahren nach Anspruch 1, dadurch gekennzeichnet, dass das digitale Detektor-Signal (t) durch Wegimpulse (u) in ein Schieberegister (18) eingetaktet wird, dass von jeder Position des Schieberegisters (18) ein Ausgangssignal geliefert und nach der jeweiligen Aussagekraft gewichtet wird, dass die Summe (v) aller gewichteten Ausgangssignale des Schieberegisters (18) mit einem maximal zulässigen Fehlersignal (w) verglichen wird und dass bei Unterschreiten dieser Schwelle in einem Komparator (19) ein digitales Synchronisations-Signal (z) erzeugt wird.

3. Vorrichtung zur Steurung eines Laser-Pattern-Generators für ein Laser-Schreibverfahren, mit winigstens einem Tastlaserstrahl-Detector (1) zum Empfang eines von der Oberfläche eines bearbeiten Werkstücks beeinflussten Tastlasertrahls, dadurch gekennzeichnet, dass an den Tastlaserstrahldetektor (1) ein analog/digitaler-Umwandler (2) angeschlossen ist, dessen Ausgang mit einem Synchronisator (3) und einer Steuer-Logik (4) verbunden ist, wobei die Steuer-Logik (4) an den Eingang eines Spurmuster-Speichers (5) führt, dessen Ausgang eine Verbindung für gespeicherte Daten an den Synchronisator (3) aufweist, der mit einem Weg für Korrektursignale für die Steuer-Logik (4) und einen Anschluss für die Steuerung des Laser-Pattern-Generators versehen ist.

## Claims

1. A method of increasing security during the detection of reference data in a laser writing method by means of a laser pattern generator, a scanning laser beam affected by the surface of a machined workpiece being received by at least one scanning laser beam detector (1), characterized in that the signals of the scanning laser beam, which - when an entry code is applied to the edge of the workpiece - are affected by the latter and are detected by the scanning laser beam detector (1), are converted into a digital signal which is supplied to a control logic (4) and a synchronizer (3), the control logic (4) is supplied by a control signal to a track pattern store (5), the control logic (4) then controls the output of the stored track pattern, the said track pattern is supplied to the synchronizer (3), the digital detector signal of the scanning laser beam and the synthetic signal are compared by means of the synchronizer (3) and the relevant signal received is emitted for the control of the opposite movement of the writing laser beam and the workpiece.

2. A method according to Claim 1, characterized in that the digital detector signal (t) is clock-timed into a shift register (18) by path pulses (u), an output signal is delivered from each position of the shift register (18) and is weighted in accordance with the respective output level, the sum (v) of all the weighted output signals of the writing register (18) is compared with the maximum permissible error signal (w) and when this threshold is not exceeded a digital synchronization signal (z) is generated in a comparator (19).

3. A device for controlling a laser pattern generator for a laser writing process, having at least one scanning laser beam detector (1) for receiving a scanning laser beam affected by a surface of a machined workpiece, characterized in that an analogue/digital converter (2), the output of which is connected to a synchronizer (3) and a control logic (4), is connected to the scanning laser beam detector (1), the control logic (4) leading to the input of a track pattern store (5), the output of which has a connexion for stored data to the synchronizer (3) which is provided with a path for correction signals for the control logic (4) and with a connexion (6) for controlling the laser pattern generator.

## Revendications

1. Méthode pour augmenter la sécurité de la reconnaissance de données de référence pour un procédé d'écriture par laser au moyen d'un générateur de modèles à laser, un faisceau laser d'exploration influencé par la surface d'une pièce usinée étant reçu par au moins un détecteur de faisceau laser d'exploration (1), **caractérisée en ce** que les signaux du faisceau laser d'exploration influencés par la pièce usinée au moyen d'un code d'entrée placé sur le bord de ladite pièce usinée et détectés par un détecteur de faisceau laser d'exploration (1), sont transformés en un signal numérique transmis à une logique de commande (4) et transmis à un synchroniseur (3); que la logique de commande (4) est transmise par un signal de commande à une mémoire de modèles de pistes (5); que la logique de commande (4) assure ensuite la sortie du modèle de piste stocké; que ce modèle de piste est transmis au synchroniseur (3); que, au moyen du synchroniseur (3), le signal numérique de détecteur du faisceau laser d'exploration et le signal synthétique sont comparés et que le signal significatif reçu est sorti pour la commande du mouvement relatif du faisceau laser d'écriture et de la pièce usinée.

2. Méthode selon la revendication 1, caractérisée en ce que le signal numérique de détecteur (t) est injecté par des impulsions de déplacement (u) dans un registre de décalage (18); que chaque position du registre de décalage (18) fournit un signal de sortie qui est pondéré en fonction de la valeur logique respective; que la somme (v) de tous les signaux de sortie pondérés du registre de décalage (18) est comparée avec un signal d'erreur maximum admissible (w); et que, lors d'un dépassement vers le bas de ce seuil, un signal de synchronisation numérique (z) est généré dans un comparateur (19).

3. Dispositif pour commander un générateur de modèles à laser pour un procédé d'écriture par laser, comprenant au moins un détecteur de faisceau laser d'exploration (1) pour la réception d'un faisceau laser d'exploration influencé par la surface d'une pièce usinée, **caractérisé en ce** qu'au détecteur de faisceau laser d'exploration (1) est raccordé un convertisseur analogique-numérique (2) dont la sortie est reliée à un synchroniseur (3) et à une logique de commande (4), la logique de commande (4) conduisant à l'entrée d'une mémoire de modèles de pistes (5) dont la sortie comprend une liaison pour la transmission des données stockées à un synchroniseur (3) muni d'un chemin pour des signaux de correction pour la logique de commande (4) et d'un branchement (6) pour la commande du générateur de modèles à laser.

FIG.1

FIG.2

FIG.3

FIG.4

EP 0 253 764 B1